# EUROPEAN PATENT SPECIFICATION

(11) **EP 2 757 176 B1**
(45) Date of publication and mention of the grant of the patent: **03.10.2018**
(21) Application number: 14151482.8
(22) Date of filing: 16.01.2014
(51) Int. Cl.: C23C 28/00, F24S 70/30, C23C 14/06, C23C 14/58, C23C 14/02

(54) **MULTILAYER COATING WITH HIGH ABSORPTION OF SOLAR ENERGY AND WITH LOW THERMAL EMISSIVITY, RELATED CERMET COMPOSITE, A USE THEREOF AND PROCESSES FOR PRODUCING THEM**
MEHRLAGIGE BESCHICHTUNG MIT HOHER ABSORPTION VON SONNENENERGIE UND NIEDRIGER THERMISCHER ABSTRAHLUNG, ZUGEHÖRIGER METALL-KERAMIK-VERBUNDWERKSTOFF, DEREN VERWENDUNG UND VERFAHREN ZU DEREN HERSTELLUNG
REVÊTEMENT MULTICOUCHE À HAUTE ABSORPTION DE L'ÉNERGIE SOLAIRE ET FAIBLE ÉMISSIVITÉ THERMIQUE, COMPOSITE CERMET ASSOCIÉ, LEUR UTILISATION ET PROCÉDÉS POUR LEUR FABRICATION

(30) Priority: 16.01.2013 IT VI20130006
(43) Date of publication of application: 23.07.2014
(73) Proprietor: Fondazione Bruno Kessler, 38122 Trento (IT)
(72) Inventor: BENSAADA, LAIDANI, Nadhira, 38123 TRENTO (IT); BARTALI, Ruben, 38123 TRENTO (IT); MICHELI, Victor, 38017 MEZZOLOMBARDO (TN) (IT); GOTTARDI, Gloria, 38017 MEZZOLOMBARDO (TN) (IT); CREMA, Luigi, 38056 LEVICO TERME (TN) (IT)
(74) Representative: Bonini, Ercole

(56) References cited:
- WO-A1-2012/065648
- WO-A2-2009/107157
- US-A- 5 523 132
- US-A1- 2010 092 747
- US-A1- 2010 294 263
- US-A1- 2011 088 687

## Description

### Technical field

The invention concerns a multilayer coating with high absorption of solar energy and a low thermal emissivity. Moreover, a cermet composite is proposed having high absorption of solar energy and a low thermal emissivity. Processes for producing them are described. The coating and the cermet composite are mainly used in the field of solar thermal systems for producing solar thermal and/or electric energy.

### State of the art

Solar thermal systems are devices that make it possible to capture solar light, store it and use it in the most various manners, in particular with the purpose of heating running water, replacing boilers supplied with natural gas or for producing electricity (solar thermal electricity). The photo-thermal conversion efficiency in such systems with average and high temperatures strongly depends upon the optical properties and on the thermal stability of the materials of the components used in the solar collector.

Systems are divided into low-temperature systems (up to 120°C), medium-temperature systems (up to around 500°C) and high-temperature systems (around 1000°C) which are used especially in large industrial plants.

"The solar collector" is the core device on which this technology is based. The collectors are crossed by a thermovector fluid canalized in a solar circuit that will conduct it to an accumulator. The accumulator has the function of storing as much thermal energy as possible so as to be able to use it at a later moment, when needed. There are various types, the most recent ones are vacuum tube solar collectors.

A solar thermal system is always made up of at least the following units: one or more collectors that give up the heat of the sun to the fluid [there are various types of these, from a simple copper plate crossed by a serpentine and painted with black paint (which can be easily damaged and has a high emission in the infrared spectrum), to a selective panel that is treated with titanium dioxide, to the vacuum collector] and a storage tank of the fluid. It is also worth mentioning CSP (Concentrating Solar Power) systems, which combine the production of heat and electricity, for example by using a Stirling motor.

Different materials are known having a high absorption of solar energy and a low thermal emissivity that, at low temperatures and at ambient pressure, have the selective capability of greatly absorbing solar light and that have a low thermal emissivity, i.e. with an absorption of at least 0.90 in the visible range and a thermal emissivity of at most 0.10.

At high temperatures (around 350°C) and in vacuum conditions that are similar to those present in a vacuum tube (5·10⁻³ Pa), these materials, among which also materials like cermet (ceramic-metal composites), are often unstable, i.e. they have a reduced solar absorption and/or an increase of the thermal emissivity. A thermal emissivity of 0.06 at 100°C leads to an emissivity of around 0.10 at 350°C. A low emissivity of 0.06 at 350°C negatively affects the solar absorption since the sun and black body spectra at 350°C slightly overlap and it is necessary for the passage from low reflectance in the field of solar wavelengths to high reflectance in the field of infrared wavelengths to be well defined.

The state of the art offers different coatings with high absorption of solar energy and a low thermal emissivity, like for example patent US 5 523 132, which describes cermet compositions comprising silicon or aluminium oxide and metals like copper, nickel, gold or molybdenum, or patent application US 2010/0092747 A1, which proposes a film that reflects infrared light made up of titanium oxide and niobium, vanadium, tantalum, tungsten or chromium in the ion form.

### Presentation of the invention

The purpose of the present invention is to propose a coating with high absorption of solar energy and a low thermal emissivity and to provide relative materials, in particular cermet composites, with high absorption of solar energy and a low thermal emissivity that can be used in such coatings and at temperatures of around 350°C and in vacuum conditions have a high absorption of solar energy and have a low thermal emissivity. Such coatings are therefore selective, in terms of spectral absorption. Such coatings and materials must be suitable for being used in solar thermal systems.

The purpose mentioned above and others that shall be highlighted in the rest of the description are achieved with a multilayer coating as defined in the first claim. The layer of molybdenum of the coating according to the invention is applied on a substrate of stainless steel, for example on a concentrator tube.

Contrary to the results of theoretical calculations (E. Wäckelgård et al. in "New Development of spectrally selective solar-absorbing coating for low and intermediate temperature applications", World Renewable Energy Congress XI, 25-30 September 2010, Abu Dhabi, UAE) for different cermet composites and their optical properties, which clearly promoted coatings with layers of SiO₂ and ZrO₂ with tungsten, surprisingly the combination TiO₂-Nb was found to be more suitable at temperatures of around 350°C and in vacuum conditions to obtain high solar light absorption values and low values for thermal emissivity.

TiO₂ is a cermet matrix with a high refractive index, it has a good transparency in the visible range, a high melting point (1843°C) and a good chemical and mechanical stability. Niobium is a refractory reflective metal that has extraordinary heat and wear resistance and has a melting point of 2477°C.

The different layers of the coating can obviously contain traces of other elements or composites that are common in the field, and this is due for example to the impurities in the raw materials used.

The thin layer of molybdenum acts as an infrared-reflecting layer. The layer of SiO₂ on the other hand acts as an anti-reflective element to visible light. The layers have the order as indicated in claim one. In one preferred embodiment of the invention, TiO₂ is amorphous.

According to one variant of the invention, the layer of TiO₂ and niobium is a single layer. This layer has a constant atomic fraction of niobium in the matrix of titanium dioxide, i.e. an atomic fraction that is constant in the entire volume of the layer. Whereas, according to another more advantageous variant of the invention, the layer of TiO₂ and niobium is a double layer that is made up of two sublayers that are essentially made up of TiO₂ and niobium metal with different concentrations of niobium in TiO₂, preferably a first base sublayer with a high atomic fraction of niobium and a second sublayer with a low atomic percentage of niobium that has grown on the first sublayer. In this last case the results that can be obtained in terms of absorption of the solar light and of the thermal emissivity are better. The double layer has the advantage of having less reflectance in the UV region (0.3 - 0.4 µm).

In one particularly preferred variant of the invention, said single layer is essentially made up of TiO₂ and niobium metal in which the concentration of niobium in the TiO₂ corresponds to 27 - 34 at.%, preferably to 29.6 - 32.0 at.%, more preferably to 30.2 - 31.4 at.%, even more preferably to around 30.8 at.%. Optimal values are reached at 350°C when the concentration of niobium in the TiO₂ is around 30.8 at.%; the absorption in the visible range is 0.93 and the emissivity in the infrared range (4 µm) ε = 0.09.

In one variant embodiment of the invention, this single layer has a thickness of between 33 and 62 nm, preferably 42.5 - 52.5 nm, more preferably 47.5 nm. In one even more preferred variant of the invention, said double layer is made up of a first sublayer that is essentially made up of TiO₂ and niobium metal in which the concentration of niobium in the TiO₂ corresponds to 27 - 34 at.%, preferably to 29.6 - 32.0 at.%, more preferably to 30.2 - 31.4 at.%, even more preferably around 30.8 at.% (therefore corresponds to the composition described for the single layer); and by a second sublayer that is essentially made up of TiO₂ and niobium metal in which the concentration of niobium in the TiO₂ corresponds to 12 - 18 at.%, preferably to 14.4 - 15.6 at.%, more preferably to 14.7 - 15.3 at.%, even more preferably around 15.0 at.%. For the more preferred indicated concentrations, the absorption at 350°C in the visible range is 0.93 and the emissivity in the infra-red range (4 µm) ε = 0.09.

The values for the absorption refer to the entire solar spectrum (0.3 µm - 4.045 µm), whereas the emissivity refers to the field 0.3 µm - 100 µm wherein the data measured have been extrapolated from 20 µm to 100 µm.

In one variant embodiment of the invention, the first sublayer has a thickness of between 10 and 50 nm, preferably between 26 and 50 nm, more preferably 34 - 42 nm, even more preferably around 38 nm, and the second sublayer has a thickness of between 17 and 70 nm, preferably of between 17 and 38 nm, more preferably 24 - 31 nm, even more preferably around 27 nm. Another thickness of the second sublayer is 28.5 nm.

Advantageously, in the variant embodiments described, the layer of molybdenum has a thickness greater than 100 nm. Preferably, the layer of SiO₂ has a thickness of 50 to 150 nm, preferably 77-93 nm, more preferably around 85 nm.

Advantageously, inside the ranges indicated for the concentration of niobium and for the thicknesses, great thicknesses are combined with lower concentrations of niobium and smaller thicknesses with higher concentrations of niobium.

Another aspect of the invention concerns a laminar or tubular material, in particular components of a solar thermal system, which are coated with a coating according to the invention. Tubular materials are preferably vacuum tube solar collectors.

A further aspect of the invention concerns a cermet composite with high absorption of solar energy and a low thermal emissivity essentially made up of TiO₂ and niobium metal in which the concentration of niobium in the TiO₂ corresponds to 27 - 34 at.%, preferably to 29.6 - 32.0 at.%, more preferably to 30.2 - 31.4 at.%, even more preferably to around 30.8 at.%. The preferred composite at 350°C has high absorption of 0.93 in the visible range and a lower emissivity in the infrared range (4 µm) of 0.09.

The invention furthermore proposes a cermet composite that is essentially made up of TiO₂ and niobium metal in which the concentration of niobium in the TiO₂ corresponds to 12 - 18 at.%, preferably to 14.4 - 15.6 at.%, more preferably to 14.7 - 15.3 at.%, even more preferably around 15.0 at.%. This second type of cermet is particularly advantageous in combination with the first type of cermet composite according to the above, and precisely in the aspect of the invention that concerns the fact that said first type of cermet composite is in the form of a layer and is coated by a layer of the second type of cermet, as indicated in claim 9.

The closer we get to the most preferred values indicated for the concentration of niobium in the cermet, the higher the values which can be measured for the absorption and the more the emissivity values decrease.

Of course, the two types of cermet composites can be comprised in coatings, in particular in coatings that are useful in solar thermal systems. Inside these coatings they can be combined with other antireflective layers in the visible range or infrared reflective layers with respect to those indicated for the coating according to the invention, or they can also be combined with other layers comprising spectral selective absorbing materials.

A further aspect of the invention concerns a process for the production of a cermet composite according to the invention in which the niobium is incorporated in the TiO₂ through a co-sputtering vapour deposition method.

Another aspect of the invention concerns a process for the production of a coating according to the invention on a substrate that comprises the following steps:
a) preparation of a substrate, preferably of stainless steel;
b) deposition of a layer of molybdenum on said substrate;
c) deposition of a layer of a composite that is essentially made up of TiO₂ and niobium metal on the layer of molybdenum;
d) deposition of a layer of SiO₂ on the layer of the composite of TiO₂ and niobium.

The molybdenum can be for example deposited through DC-sputtering of the molybdenum target. Preferably, the layer of molybdenum is deposited in argon at a pressure of 1-1.5 mTorr. Lower pressures are preferred, but limited by the parameters of the process. Advantageously, on the substrate of molybdenum in the solid state with the composite TiO₂/Nb is deposited with a controlled thickness and atomic fraction of metal. The cermet layers or film are prepared by incorporating niobium in a matrix TiO₂ by using a physical vapour deposition co-sputtering method. The films of TiO₂ are deposited through RF-plasma-sputtering (RF = radio-frequency) of a target of titanium oxide, whereas niobium is deposited through RF-magnetron-sputtering of a target of niobium. The cermet can also be deposited through sputtering of a target made up of TiO₂ and niobium.

Advantageously, the films are prepared by using argon (30 cubic centimetres standard/minute) at 0.01 Torr. Advantageously, the samples are deposited with a floating potential and are not heated from the outside. The silicon dioxide is preferably deposited by means of a reactive sputtering of silicon or through RF-sputtering of a target SiO₂. In the case of RF-sputtering, preferred parameters are the use of argon with a pressure of around 3 mTorr. In the case of reactive silicon sputtering, advantageously, a mixture of argon/oxygen is used (around 3% of oxygen) at a pressure of 5 - 10 mTorr. Both methods obtain films of the same quality.

The concentrations of niobium and the thicknesses illustrated above for the coating and the cermet composite can be applied *mutatis mutandis* to the processes according to the invention.

A last aspect of the invention concerns the use of cermet composite according to the invention in applications of transformation of the solar light into thermal and/or electric energy.

Variant embodiments of the invention are object of the dependent claims. The description of preferred embodiments of the coating, of the cermet composite, of the production processes, of the use according to the invention is given as an example and not for limiting purposes with reference to the attached drawing tables.

### Brief description of the drawings

- Fig. 1 shows the general scheme of a coating according to the invention;
- fig. 2 shows a first embodiment of a coating according to the invention with a single layer of TiO₂-Nb;
- fig. 3 shows a second embodiment of a coating according to the invention with a double TiO₂-Nb layer;
- fig. 4 shows the Auger spectroscopy spectra of niobium metal and of oxidised niobium;
- fig. 5 shows the Auger spectroscopy spectrum of a TiO₂/Nb composite according to the invention;
- fig. 6 shows, together with the solar spectrum and with the emission of a black body that has been normalised to 1 at 350°C, the optical properties (reflectance spectrum in visible light and in the infrared region) of an embodiment of the coating according to fig. 2 at 350°C;
- fig. 7 shows together with the solar spectrum and with the emission of a black body that has been normalised to 1 at 350°C, the optical properties (reflectance spectrum in the visible light and in the infrared region) of an embodiment of the coating according to fig. 3 at 350°C.

### Description of the embodiments

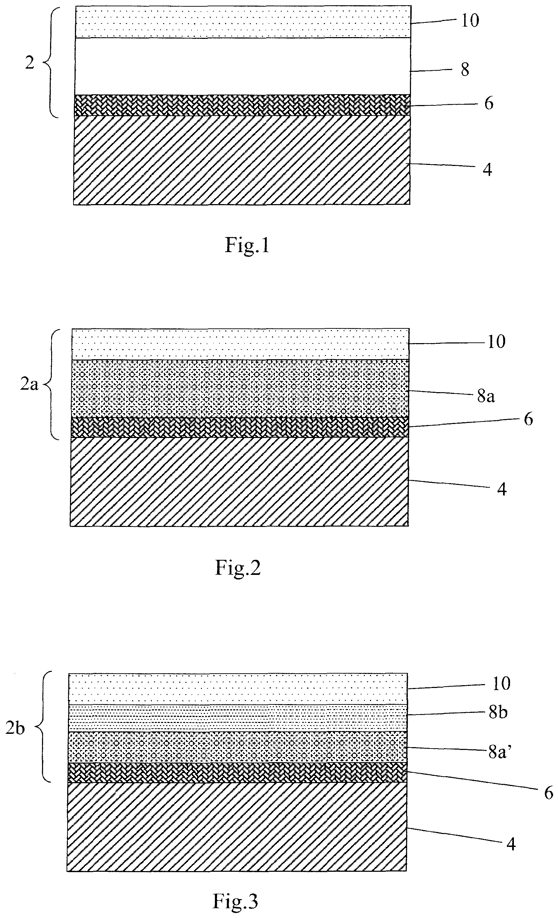

Fig. 1 illustrates the general scheme of a coating **2** according to the invention that is applied on a stainless steel substrate **4.** The coating comprises three layers, and precisely a first layer **6** of molybdenum, a second layer **8** of a cermet composite of a ceramic matrix of TiO₂ which comprises niobium metal and a third layer **10** of SiO₂.

Fig. 2 shows a first embodiment **2a** of the coating according to fig. 1. The coating **2a** is applied onto a stainless steel substrate **4.** The layers of molybdenum **6** and of silicon oxide **10** are repeated. The layer **8a** corresponds to a composite of TiO₂ and niobium metal in which the concentration of niobium corresponds to around 30.8 at.%.

Fig. 3 shows a second embodiment **2b** of a coating according to fig. 1. The coating **2b** is applied onto a stainless steel substrate **4.** The layers of molybdenum **6** and of silicon oxide **10** are repeated. The intermediate layer corresponds to two distinct films, and precisely to a first film **8a'** with a composite of TiO₂ and niobium metal in which the concentration of niobium corresponds to around 30.8 at.% and to a second film **8b** with a composite of TiO₂ and niobium metal in which the concentration of niobium corresponds to around 15 at.%. The materials of the layers **8a** and **8a'** are the same, but their thicknesses are different. Example values for the concentrations of niobium inside the composite and for the thicknesses of the different layers are found in the description of the invention.

The niobium contained in the composites/coatings according to the invention is found in the metal state. In order to verify the metal state of the niobium in the matrix of TiO₂ an Auger spectroscopic analysis (AES, Auger Electron Spectroscopy) was carried out by using a PHI 4200.

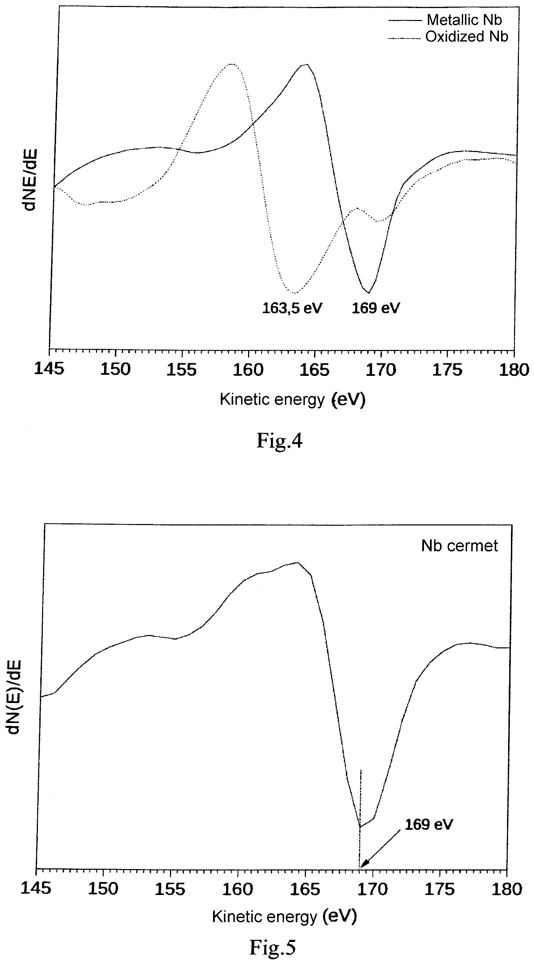

Fig. 4 shows the differential AES spectra of two references, in particular of niobium metal (pure metal film, 99.99%, Goodfellow) and of oxidised niobium. The spectra were acquired after an erosion of the surface layers of the samples for eliminating contaminants and the native oxide formed in contact with the environment.

The Auger transitions show substantial differences for the two types of niobium: the differential spectrum for the niobium metal is characterised by a single minimum at 169 eV in the energy range 155-180 eV; whereas for the oxidised niobium, the form of the differential spectrum is different, in that there are two minimums, and for the greater excursion, the energy position is moved towards the low kinetic energies, as it should be for an oxide. The analysis of different transitions of niobium can be used to identify the chemical state of niobium in the composite TiO₂/Nb.

Fig. 5 shows the AES differential spectrum of a TiO₂/Nb composite according to the invention in which the form of the line for niobium is similar to that of the metal Nb and shows the main characteristic at 169 eV. Niobium is therefore present only in the metal form.

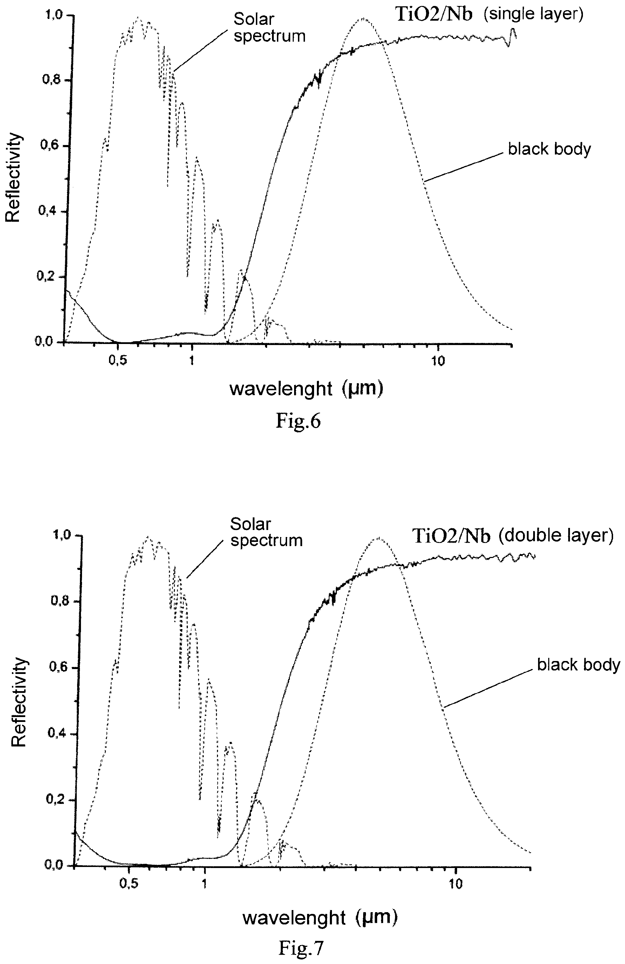

Fig. 6 shows together with the solar spectrum and with the emission of a black body normalised to 1 at 350°C the reflectance spectrum in the visible light and in the infrared region of the embodiment of the coating according to fig. 2, i.e. for a version with TiO₂/Nb in a single layer (30.8 at.% of niobium).

Fig. 7 shows together with the solar spectrum and with the emission of a black body at 350°C the reflectance spectrum in the visible light and in the infrared region of the embodiment of the coating according to fig. 3, i.e. for a version with TiO₂/Nb in a double layer (respectively at 30.8 at.% and 15.0 at.% of niobium).

In both cases, it is possible to see a high absorption in the solar spectrum and a low thermal emissivity. The version with a double layer has absorption coefficients which are slightly greater with respect to the version with a single layer.

The cermet according to the invention shows selective properties with high reflectance, i.e. low emissivity (emissivity = 1 - reflectance), in the infrared and simultaneously a high absorbance in the visible range, such a behaviour is not for example obtained from the combination of titanium oxide with ionic niobium as proposed in document US 2010/0092747 A1 (in particular, we refer to figure 7 of such a document).

The tool used for measuring the solar spectral field was a UV/VIS/NIR double beam spectrophotometer (Perkin Elmer Lambda 900). It is a dispersive type that uses a white light source and a few grating monochromators to create light with a specific wave length. A detector collects the part of light that is reflected or transmitted according to its setting and transfers it to a computer for further processing. As a reference a Spectralon sample has been used.

The tool used for carrying out reflectance measurements in the infrared field was a FT-IR (Fourier Transform Infrared) spectrophotometer TENSOR 27 by Bruker. It is provided with a gold-coated integrating sphere. The measured wavelength goes from 2.5 to 22 µm (450 cm⁻¹). According to standard EN 673, the thermal emissivity should be calculated by covering at least up to 50 µm. The reflectance is thus extrapolated at 100 µm.

All the composites/coatings according to the invention are stable at 350°C and in vacuum (5·10⁻³ Pa) in terms of mechanical, chemical stability, and of maintaining the optical (thermal absorption/emissivity) properties.

In the rest of the description we shall describe the process applied for testing the thermal resistance of the samples in a vacuum. The samples had dimensions of 40x40 mm. The heat source was a tube oven (ENTECH, Sweden) with a tube chamber that is situated inside it. The maximum temperature, which was reached at the centre of the oven, was of 1100°C. This means that the temperature was not homogeneous inside the oven. In order to reduce this effect, the samples to be treated thermally were always kept at a fixed position inside the oven. A small metal box (100x50x25 mm) was used for containing the samples. The box was placed close to the centre of the oven through a mechanical fixing. Thanks to its thermal mass, the box compensates for the temperature inside the box. A thermocouple mounted on an internal surface of the lid of the box was used for monitoring the temperature and this temperature was considered the temperature of the sample.

The chamber was connected to a vacuum system that was provided with an Edwards HT10 diffusion pump with a capacity of 3000 l/s (nitrogen). A gas dosage valve (EVD 010H, Pfeiffer) was installed between the chamber and the pump for controlling the pumping speed so that the pressure in the chamber could be adjusted to the value closest to the actual value in a vacuum system. A compact full range manometer (Balzers PKR 250) was installed on the end of the chamber to monitor the pressure.

The selected temperature was 350°C, the pressure 5·10⁻³ Pa with an exposure of 240 hours.

The invention reached its purpose of proposing a coating and a relative cermet composite which at temperatures of around 350°C and in vacuum conditions (around 5·10⁻³ Pa) is characterised in that it has a high solar energy absorption and a low thermal emissivity that are also stable over time. Such cermet coatings/composites are thus, in terms of absorption, spectrally selective. Such coatings and materials are suitable for being used in solar thermal systems. When put into practice, the coating and the materials that are coated in it, the cermet composite, its use and the processes for producing the coating and the cermet composite object of the invention, can undergo further modifications or variants that have not been described. Wherever such modifications or such variants are covered by the following claims, they should all be considered protected by the present patent.

## Claims

1. Multilayer coating with high absorption of solar energy and with low thermal emissivity, applied on a substrate (4), comprising:
(a) a first layer of molybdenum;
(b) a second layer made up of TiO₂ and niobium metal; and
(c) a third layer of SiO₂.

2. A multilayer coating according to claim 1, **characterised in that** said second layer is a single layer or a double layer that is made up of two sublayers made up of TiO₂ and niobium metal having different concentrations of niobium in the TiO₂.

3. A multilayer coating according to claim 2, **characterised in that** said single layer is made up of TiO₂ and niobium metal in which the concentration of niobium in the TiO₂ corresponds to 27 - 34 at.%, preferably to 29.6 - 32.0 at.%, more preferably to 30.2 - 31.4 at.%, even more preferably to around 30.8 at.%.

4. A multilayer coating according to claim 2, **characterised in that** said double layer is made up of a first sublayer made up of TiO₂ and niobium metal in which the concentration of niobium in the TiO₂ corresponds to 27 - 34 at.%, preferably to 29.6 - 32.0 at.%, more preferably to 30.2 - 31.4 at.%, even more preferably to around 30.8 at.%; and of a second sublayer made up of TiO₂ and niobium metal wherein the concentration of niobium in the TiO₂ corresponds to 12 - 18 at.%, preferably to 14.4 - 15.6 at.%, more preferably to 14.7 - 15.3 at.%, even more preferably to around 15.0 at.%.

5. A coating according to claim 3, **characterised in that** said single layer has a thickness of between 33 and 62 nm, preferably of between 42.5 - 52.5 nm, more preferably of around 47.5 nm, **in that** the layer of molybdenum has a thickness greater than 100 nm and **in that** the layer of SiO₂ has a thickness of between 50 and 150 nm, preferably between 77-93 nm, more preferably of around 85 nm.

6. A coating according to claim 4, **characterised in that** said first sublayer has a thickness of between 10 and 50 nm, preferably between 26 and 50 nm, more preferably 34 - 42 nm, even more preferably 38 nm, **in that** said second sublayer has a thickness of between 17 and 70 nm, preferably of between 17 and 38 nm, more preferably of 24 - 31 nm, even more preferably 27 nm, **in that** the layer of molybdenum has a thickness greater than 100 nm and **in that** the layer of SiO₂ has a thickness of 50 to 150 nm, preferably 77-93 nm, more preferably around 85 nm.

7. Laminar or tubular material, in particular components of a solar thermal system, coated with a coating according to any one of claims 1 to 6.

8. Cermet composite, comprised in a coating, with high solar energy absorption and low thermal emissivity made up of TiO₂ and niobium metal wherein the concentration of niobium in the TiO₂ corresponds to 27 - 34 at.%, preferably to 29.6 - 32.0 at.%, more preferably to 30.2 - 31.4 at.%, even more preferably to around 30.8 at.%.

9. Cermet composite according to claim 8, **characterised in that** said cermet composite is in the form of a layer which is covered by a layer of a cermet composite made up of TiO₂ and niobium metal wherein the concentration of niobium in the TiO₂ corresponds to 12 - 18 at.%, preferably to 14.4 - 15.6 at.%, more preferably to 14.7 - 15.3 at.%, even more preferably to around 15.0 at.%.

10. Production process of a cermet composite according to claim 8 or 9 wherein the niobium is incorporated in the TiO₂ through a Radio-Frequency-plasma co-sputtering vapour deposition method in an inert atmosphere.

11. Process for producing a coating according to any one of claims from 1 to 6 on a substrate comprising the following steps:
(a) preparation of a substrate, preferably of stainless steel;
(b) deposition of a layer of molybdenum on said substrate;
(c) deposition of a layer of a composite made up of TiO₂ and niobium metal by Radio-Frequency-plasma co-sputtering vapour deposition in an inert atmosphere on said layer of molybdenum;
(d) deposition of a layer of SiO₂ on said layer of said composite of TiO₂ and niobium.

12. Use of said cermet composite according to one of claims 8 or 9 in applications for transforming solar light into thermal and/or electric energy.

## Patentansprüche

1. Mehrschichtige Beschichtung mit hoher Aufnahmefähigkeit von Sonnenenergie und geringem thermischen Emissionsvermögen, die auf ein Trägermaterial (4) aufgebracht wird, umfassend:
(a) eine erste Schicht aus Molybdän;
(b) eine zweite Schicht, die aus TiO₂ und Niobmetall gebildet ist; und
(c) a eine dritte Schicht aus SiO₂.

2. Mehrschichtige Beschichtung nach Anspruch 1, **dadurch gekennzeichnet, dass** die zweite Schicht eine Einzelschicht oder eine Doppelschicht ist, die aus zwei Unterschichten gebildet ist, die aus TiO₂ und Niobmetall mit unterschiedlichen Niobkonzentrationen im TiO₂ gebildet sind.

3. Mehrschichtige Beschichtung nach Anspruch 2, **dadurch gekennzeichnet, dass** die Einzelschicht aus TiO₂ und Niobmetall gebildet ist, wobei die Niobkonzentration im TiO₂ 27 - 34 Atom-%, bevorzugt 29,6 - 32,0 Atom-%, besonders bevorzugt 30,2 - 31,4 Atom-%, und noch besonders bevorzugt ungefähr 30,8 Atom-% beträgt.

4. Mehrschichtige Beschichtung nach Anspruch 2, **dadurch gekennzeichnet, dass** die Doppelschicht aus einer ersten Unterschicht gebildet ist, die aus TiO₂ und Niobmetall gebildet ist, wobei die Niobkonzentration im TiO₂ 27 - 34 Atom-%, bevorzugt 29,6 - 32,0 Atom-%, besonders bevorzugt 30,2 - 31,4 Atom-% und noch besonders bevorzugt ungefähr 30,8 Atom-% beträgt; und aus einer zweiten Unterschicht, die aus TiO₂ und Niobmetall gebildet ist, wobei die Niobkonzentration im TiO₂ 12 - 18 Atom-%, bevorzugt 14,4 - 15,6 Atom-%, besonders bevorzugt 14,7 - 15,3 Atom-% und noch besonders bevorzugt ungefähr 15,0 Atom-% beträgt.

5. Beschichtung nach Anspruch 3, **dadurch gekennzeichnet, dass** die Einzelschicht eine Dicke zwischen 33 und 62 nm, bevorzugt zwischen 42,5 und 52,5 nm, besonders bevorzugt von ungefähr 47,5 nm aufweist, dass die Molybdänschicht eine Dicke von mehr als 100 nm aufweist und dass die SiO₂-Schicht eine Dicke zwischen 50 und 150 nm, bevorzugt zwischen 77 und 93 nm, besonders bevorzugt von ungefähr 85 nm aufweist.

6. Beschichtung nach Anspruch 4, **dadurch gekennzeichnet, dass** die erste Unterschicht eine Dicke zwischen 10 und 50 nm, bevorzugt zwischen 26 und 50 nm, besonders bevorzugt von 34 - 42 nm und noch besonders bevorzugt von 38 nm aufweist, dass die zweite Unterschicht eine Dicke zwischen 17 und 70 nm, bevorzugt zwischen 17 und 38 nm, besonders bevorzugt von 24 - 31 nm und noch besonders bevorzugt von 27 nm aufweist und dass die Molybdänschicht eine Dicke von mehr als 100 nm aufweist und dass die SiO₂-Schicht eine Dicke zwischen 50 und 150 nm, bevorzugt von 77-93 nm, besonders bevorzugt von ungefähr 85 nm aufweist.

7. Lamellen- oder rohrförmiges Material, insbesondere Teile einer solarthermischen Anlage, die mit einer Beschichtung nach einem der Ansprüche 1 bis 6 beschichtet sind.

8. Metallkeramikverbundstoff, der in einer Beschichtung mit hoher Aufnahmefähigkeit von Sonnenenergie und geringem thermischen Emissionsvermögen umfasst ist, die aus TiO₂ und Niobmetall gebildet ist, wobei die Niobkonzentration im TiO₂ 27 - 34 Atom-%, bevorzugt 29,6 - 32,0 Atom-%, besonders bevorzugt 30,2 - 31,4 Atom-% und noch besonders bevorzugt ungefähr 30,8 Atom-% beträgt.

9. Metallkeramikverbundstoff nach Anspruch 8, **dadurch gekennzeichnet, dass** der Metallkeramikverbundstoff in Form einer Schicht vorliegt, die mit einer Schicht aus Metallkeramikverbundstoff bedeckt ist, der aus TiO₂ und Niobmetall gebildet ist, wobei die Niobkonzentration im TiO₂ 12 - 18 Atom-%, bevorzugt 14,4 - 15,6 Atom-%, besonders bevorzugt 14,7 - 15,3 Atom-%, und noch besonders bevorzugt ungefähr 15,0 Atom-% beträgt.

10. Herstellungsverfahren eines Metallkeramikverbundstoffes nach Anspruch 8 oder 9, wobei das Niob durch ein Hochfrequenz-Plasma-Sputter-Dampfabscheidungsverfahren in einer Inertatmosphäre in das TiO₂ eingebracht wird.

11. Verfahren zur Herstellung einer Beschichtung nach einem der Ansprüche ab 1 bis 6 auf einem Trägermaterial, umfassend die folgenden Schritte:
(a) Herstellen eines Trägermaterials, bevorzugt aus Edelstahl;
(b) Abscheiden einer Molybdänschicht auf dem Trägermaterial;
(c) Abscheiden einer Verbundstoffschicht, gebildet aus TiO₂ und Niobmetall durch eine Hochfrequenz-Plasma-Sputter-Dampfabscheidung in einer Inertatmosphäre auf der Molybdänschicht;
(d) Abscheidung einer SiO₂-Schicht auf der Verbundstoffschicht aus TiO₂ und Niob.

12. Verwendung des Metallkeramikverbundstoffes nach einem der Ansprüche 8 oder 9 in Anwendungen zum Umformen von Sonnenlicht in Wärme- und/oder Elektroenergie.

## Revendications

1. Revêtement multicouche à haute absorption d'énergie solaire et à faible émission thermique, appliqué sur un substrat (4), comprenant:
(a) une première couche de molybdène;
(b) une seconde couche constituée de TiO₂ et de niobium métallique; et
(c) une troisième couche de SiO₂.

2. Revêtement multicouche selon la revendication 1, **caractérisé en ce que** ladite seconde couche est une couche unique ou une double couche constituée de deux sous-couches constituées de TiO₂ et de métal niobium présentant différentes concentrations de niobium dans le TiO₂.

3. Revêtement multicouche selon la revendication 2, **caractérisé en ce que** ladite couche unique est constituée de TiO₂ et de métal niobium, dans laquelle la concentration de niobium dans le TiO₂ est comprise entre 27 et 34 % at., préférablement entre 29,6 et 32,0 % at., plus préférablement entre 30,2 et 31,4 % at., encore plus préférablement est d'environ 30,8 % at.

4. Revêtement multicouche selon la revendication 2, **caractérisé en ce que** ladite double couche est constituée d'une première sous-couche constituée de TiO₂ et de métal niobium, dans laquelle la concentration de niobium dans le TiO₂ est comprise entre 27 et 34 % at., préférablement entre 29,6 et 32,0 % at., plus préférablement entre 30,2 et 31,4 % at., encore plus préférablement est d'environ 30,8 % at.; et d'une seconde sous-couche constituée de TiO₂ et métal niobium, dans laquelle la concentration de niobium dans le TiO₂ est comprise entre 12 et 18 % at., préférablement entre 14,4 et 15,6 % at., plus préférablement entre 14,7 et 15,3 % at., encore plus préférablement est d'environ 15,0 % at.

5. Revêtement selon la revendication 3, **caractérisé en ce que** ladite couche unique présente une épaisseur comprise entre 33 et 62 nm, préférablement entre 42,5 et 52,5 nm, plus préférablement est d'environ 47,5 nm, **en ce que** la couche de molybdène présente une épaisseur supérieure à 100 nm et **en ce que** la couche de SiO₂ présente une épaisseur comprise entre 50 et 150 nm, préférablement entre 77 et 93 nm, plus préférablement est d'environ 85 nm.

6. Revêtement selon la revendication 4, **caractérisé en ce que** ladite première sous-couche présente une épaisseur comprise entre 10 et 50 nm, préférablement entre 26 et 50 nm, plus préférablement entre 34 et 42 nm, encore plus préférablement de 38 nm, **en ce que** ladite seconde sous-couche présente une épaisseur comprise entre 17 et 70 nm, préférablement entre 17 et 38 nm, plus préférablement entre 24 et 31 nm, encore plus préférablement de 27 nm, **en ce que** la couche de molybdène présente une épaisseur supérieure à 100 nm et **en ce que** la couche de SiO₂ présente une épaisseur comprise entre 50 et 150 nm, préférablement entre 77 et 93 nm, plus préférablement est d'environ 85 nm.

7. Matériau laminaire ou tubulaire, en particulier des composants d'un système solaire thermique, revêtus d'un revêtement selon l'une quelconque des revendications 1 à 6.

8. Composite en cermet, constitué d'un revêtement, à haute absorption d'énergie solaire et à faible émissivité thermique, constitué de TiO₂ et de métal niobium, dans lequel la concentration de niobium dans le TiO₂ est comprise entre 27 et 34 % at., préférablement entre 29,6 et 32,0 % at., plus préférablement entre 30,2 et 31,4 % at., encore plus préférablement elle est d'environ 30,8 % at.

9. Composite en cermet selon la revendication 8, **caractérisé en ce que** ledit composite en cermet se présente sous la forme d'une couche recouverte d'une couche d'un composite en cermet constitué de TiO₂ et de métal niobium, dans lequel la concentration de niobium dans le TiO₂ est comprise entre 12 et 18 % at., préférablement entre 14,4 et 15,6 % at., plus préférablement entre 14,7 et 15,3 % at., encore plus préférablement elle est d'environ 15,0 % at.

10. Procédé de production d'un composite en cermet selon la revendication 8 ou 9, dans lequel le niobium est incorporé dans le TiO₂ via un procédé de dépôt en phase de vapeur par co-pulvérisation cathodique de plasma radiofréquence dans une atmosphère inerte.

11. Procédé de fabrication d'un revêtement selon l'une quelconque des revendications 1 à 6 sur un substrat comprenant les étapes suivantes:
(a) la préparation d'un substrat, préférablement en acier inoxydable;
(b) le dépôt d'une couche de molybdène sur ledit substrat;
(c) le dépôt sur ladite couche de molybdène d'une couche d'un composite constitué de TiO₂ et de métal niobium via dépôt en phase de vapeur par co-pulvérisation cathodique de plasma radiofréquence dans une atmosphère inerte;
(d) le dépôt d'une couche de SiO₂ sur ladite couche dudit composite de TiO₂ et du niobium.

12. Utilisation dudit composite en cermet selon l'une quelconque des revendications 8 ou 9 dans des applications de transformation de la lumière solaire en énergie thermique et/ou électrique.
